Europäisches Patentamt

**European Patent Office**

Office européen des brevets

(11) Veröffentlichungsnummer: **0 012 185 B1**

(12) **EUROPÄISCHE PATENTSCHRIFT**

(45) Veröffentlichungstag der Patentschrift: 29.09.82

(21) Anmeldenummer: 79104109.8

(22) Anmeldetag: 23.10.79

(51) Int. Cl.³: **H 03 K 5/26**, G 06 F 1/04, H 04 M 3/22

(54) Prüfschaltung für synchron arbeitende Taktgeber.

---

(30) Priorität: **12.12.78 DE 2853546**

(43) Veröffentlichungstag der Anmeldung: **25.06.80 Patentblatt 80/13**

(45) Bekanntmachung des Hinweises auf die Patenterteilung: **29.09.82 Patentblatt 82/39**

(84) Benannte Vertragsstaaten: **BE CH DE FR GB NL SE**

(56) Entgegenhaltungen:
**CA-A-871 381
DE-A-2 532 587
DE-B-1 295 627
DE-B-1 513 062
DE-B-1 562 011
US-A-3 369 190
US-A-3 600 690**

(73) Patentinhaber: **International Business Machines Corporation, Armonk, N.Y. 10504 (US)**

(72) Erfinder: **Blum, Arnold, Finkenweg 16, D-7261 Gechingen (DE)**
Erfinder: **Geng, Hellmuth Roland, Hugo-Wolf-Strasse 38, D-7033 Herrenberg (DE)**
Erfinder: **Schulze-Schölling, Hermann, Rohrweg 6c, D-7031 Gärtringen (DE)**
Erfinder: **Späth, Bernd, Höhenringweg 22, D-7000 Stuttgart 75 (DE)**

(74) Vertreter: **Teufel, Fritz, Dipl.-Phys., Schönaicher Strasse 220, D-7030 Böblingen (DE)**

---

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Prüfschaltung für synchron arbeitende Taktgeber

Die Erfindung betrifft eine Prüfschaltung für mindestens zwei synchron arbeitende Taktgeber nach dem Oberbegriff des Anspruchs 1.

In komplexen Systemen zur Informationsverarbeitung und Übertragung, beispielsweise Telefonnetzen und Rechnersystemen, werden häufig mehrere synchron arbeitende Taktgeber verwendet; diese steuern entweder die einzelnen weit entfernt voneinander liegenden Untersysteme oder dienen als Reserve, um die Steuerung des Systems bei Ausfall des Haupttaktgebers übernehmen zu können. In allen Fällen ist es erforderlich, die Synchronität dieser Taktgeber in jedem Augenblick zu gewährleisten. Dazu sind Prüfschaltungen erforderlich, die feststellen können, ob die Taktsignale auseinanderlaufen, ob einer der Taktgeber ausfällt, ob einzelne Impulse fehlen oder ob die Taktgeber insgesamt ausfallen.

Im Stand der Technik werden als Mittel zur Überwachung der einzelnen Taktgeber häufig logische Schaltungen verwendet (z.B. UND-Glieder), denen korrespondierende Impulse verschiedener Taktgeber zugeführt werden. In anderen Fällen, z.B. bei der deutschen Offenlegungsschrift 2 532 587, werden den einzelnen Taktgebern zugeordnete Zähler mit Vergleichseinrichtungen verwendet, die bei ungleichem Zählerstand ein Fehlersignal abgeben. In der deutschen Auslegeschrift 1 197 922 wird ein Multivibrator vorgeschlagen, dem zum Setzen bzw. zum Zurücksetzen die Signale zweier Taktgeber zugeführt werden. Beim Ausfall eines Taktgebers bleibt der Multivibrator stehen, ein ihm zugeordneter Kondensator entlädt sich und löst einen Alarm aus.

Diese bekannten Prüfanordnungen sind jedoch insbesondere für den Einsatz in modernen Rechenanlagen mit mehreren synchronen Taktgebern nicht optimal geeignet. Die Taktgeber sind Teil der Steuereinrichtungen des Rechners, die einen komplizierten Aufbau besitzen und daher nur schwierig auf Fehlerbedingungen zu überprüfen sind. Es ist deshalb erforderlich, dass alle bei den Taktgebern selbst auftretenden Fehler vollständig erkannt werden und von den übrigen in der Steuereinrichtung auftretenden Fehlern unterschieden werden können. Dazu muss nicht nur die in jedem Augenblick bestehende Synchronität der Taktgeber überprüft werden, sondern auch deren dynamisches Verhalten, d.h. die relative Lage von Zeitsignalen mit einem gewissen zeitlichen Abstand. Dies kann durch einfache logische Verknüpfungsglieder, z.B. UND-Glieder, nicht geleistet werden. Ausserdem muss die Prüfeinrichtung in der Lage sein, den gleichzeitigen Stillstand mehrerer Taktgeber festzustellen. Auch dies ist bei einfachen Verknüpfungsgliedern und Zählern nicht möglich. Schliesslich muss die Fehleranzeige sofort und ohne zeitliche Verzögerung nach Auftreten eines Fehlers erfolgen. Als weitere selbstverständliche Forderung muss die Prüfeinrichtung in einfacher Weise als hochintegrierte Schaltung realisierbar sein.

Aus der US-Patentschrift 3 600 690 ist eine Phasen-Differenz-Detektor-Schaltung bekannt, mit der die relative Phase der Impulse zweier Taktgeber dadurch gemessen werden kann, dass der eine Impuls über eine einstellbare Verzögerungseinrichtung dem Setzeingang eines flankengetriggerten Flip-Flops zugeführt wird, während der Impuls des zweiten Taktgebers unverzögert dem Takteingang dieses Flip-Flops zugeführt wird. Beim Überschreiten der durch die wählbare Verzögerung bestimmten Phasendifferenz gibt die Flip-Flop-Schaltung ein Fehlersignal ab. Mit dieser Schaltung kann somit die Phasenlage zweier Taktgeber überwacht werden, die kontinuierliche Impulszüge abgeben, nicht jedoch die Impulsfolgesequenz, d.h. die zeitliche Beziehung zwischen aufeinanderfolgenden Taktimpulsen (die Schaltung ist auf zwei Eingangssignale beschränkt).

Ausserdem kann diese Prüfschaltung nicht zur Überwachung sogenannter T-Ringe verwendet werden, wie man sie in mikroprogrammgesteuerten Rechnern findet und bei denen eine Taktfolgefrequenz $T_1$, $T_2$, $T_3$;.. $T_L$ erzeugt wird, deren Länge variabel ist und von der jeweils bearbeiteten Mikroinstruktion abhängt. Ein gleichzeitiger Stillstand beider Taktgeber führt bei dieser bekannten Prüfschaltung zu keiner Fehleranzeige.

Die vorliegende Erfindung stellt sich daher die Aufgabe, eine Prüfeinrichtung der eingangs genannten Art vorzuschlagen, die den Anforderungen moderner Rechensysteme entspricht.

Diese Aufgabe wird durch die im Anspruch 1 gekennzeichnete Erfindung gelöst; Ausgestaltungen der Erfindung werden in den Unteransprüchen gekennzeichnet.

Die vorgeschlagene Prüfungsschaltung verknüpft in einem Logikglied Signale verschiedener Taktgeneratoren, von denen mindestens eines um eine oder mehrere Taktdauern verzögert ist. Das Ausgangssignal des Verknüpfungsgliedes kann daher eine Indikatorkippschaltung setzen, die periodisch von einem unabhängigen Prüftaktgeber zurückgesetzt wird.

In einer Ausführungsform erfolgt die Verzögerung der Taktgeberimpulse durch Kippschaltungen vom Typ Herren-Sklave (Master-Slave), die von dem zu verzögernden Taktimpuls gesetzt und vom unabhängigen Prüftaktgeber zurückgesetzt werden.

Die Prüfschaltung kann ohne weiteres auf eine Vielzahl von Taktgebern erweitert werden; mehrere Verknüpfungsglieder mit verschiedenen Kombinationen verzögerter und nicht verzögerter Taktimpulse erlauben eine flexible Anpassung an die jeweiligen Prüf-Erfordernisse.

Die Verwendung eines unabhängigen Prüftaktgebers ermöglicht es, Fehler zu erkennen, die gleichzeitig in allen überprüften Taktgebern auftreten.

Von besonderem Vorteil ist diese Prüfschaltung bei Taktsteuerimpulsgebern in mikroprogrammierten Anlagen, deren Mikroinstruktionen unterschiedliche Ausführungsdauern aufweisen; sie lässt sich leicht auf die geforderte Anzahl von Taktimpulsen erweitern und gestattet auf einfache Weise, beliebige kürzere Folgen von Taktimpulsen zu überprüfen.

Ausführungsbeispiele der Erfindung werden nun anhand von Zeichnungen näher erläutert. Es zeigen:

Fig. 1A eine schematische Darstellung der Prüfschaltung;

Fig. 1B ein Zeitdiagramm der überprüften Taktgeber und die zeitliche Lage der überprüften Impulse;

Fig. 2 das Prinzipschaltbild einer Prüfanordnung mit mehreren Verknüpfungen der Taktimpulse.

In Fig. 1A sind zwei als T-Ringe A, B bezeichnete Taktgeber $1_a$, $1_b$ dargestellt, die auf ihren Ausgangsleitungen jeweils ein mit $T_0$ bis $T_4$ bezeichnetes Zeitsignal abgeben, das sich in periodischer Folge wiederholt. Das letzte Zeitsignal einer sich periodisch wiederholenden Folge (hier $T_4$) wird auch mit TL bezeichnet. Diese Zeitsignale werden von einem Oszillatorsignal TAKT A abgeleitet. Der Oszillator OSZ 2 enthält üblicherweise ein nachgeschaltetes Impulsformnetzwerk. Die T-Ringe $1_a$, $1_b$ bestehen beispielsweise aus einem umlaufenden rückgekoppelten Schieberegister mit Anzapfungen zwischen den einzelnen Registerstufen, an denen die Zeitsignale $T_i$ abgenommen werden. In einer anderen Ausführungsform bestehen diese T-Ringe aus fortlaufend hochgezählten Modulozählern, im Beispiel also Modulo-Vier-Zähler. Anstelle der T-Ringe mit mehreren Ausgangsleitungen für jeweils ein Zeitsignal kann auch eine normale Oszillatorschaltung mit nur einer Ausgangsleitung verwendet werden, auf der ein periodischer Ausgangsimpulszug abgegeben wird.

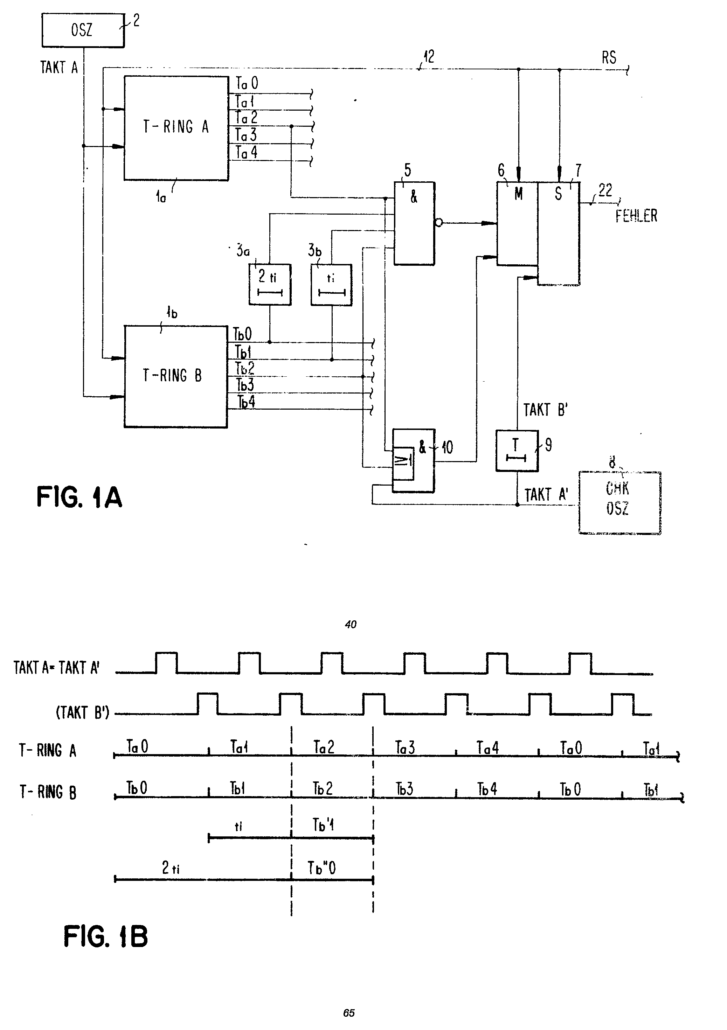

Die Impulszüge der T-Ringe sind in Fig. 1B dargestellt; aus dieser Figur geht auch die relative Lage der Zeitsignale $T_i$ zu den Oszillatorsignalen TAKT A hervor. Die Impulse TAKT A liegen jeweils in der Mitte der Zeitsignale $T_i$.

Zur Funktionsprüfung der beiden T-Ringe $1_a$, $1_b$ (die aufgrund des gemeinsam zugeführten Oszillatorsignals TAKT A synchron laufen) ist ein UND-Glied 5 vorgesehen, dem das Zeitsignal $T_{a2}$ des T-Rings A und die Zeitsignale $T_{b0}$, $T_{b1}$ und $T_{b2}$ des T-Rings B zugeführt werden. Die Zeitsignale $T_{b0}$ und $T_{b1}$ werden durch die Verzögerungsglieder 3a und 3b um die einfache bzw. die doppelte Dauer $t_i$ der Zeitsignale $T_i$ verzögert. Dadurch fallen diese Signale bei ordnungsgemässem Betrieb der Anordnung mit den Zeitsignalen $T_2$ beider T-Ringe zusammen. Dieser Fall ist in Fig. 1B dargestellt.

Im fehlerfreien Betrieb gibt somit der invertierte Ausgang des UND-Gliedes 5 ein negatives Signal ab, mit dem das Kippglied 6 der Master-Slave-Kippstufe 6, 7 gesetzt wird. Diese Flip-Flop-Schaltung dient als Anzeigeschaltung für ein Fehlersignal. Zum Setzen des Master-Teils wird diesem ausserdem ein Signal TAKT A' eines Prüfoszillators CHK OSZ 8 zugeführt. Die Übernahme des im Master-Teil 6 gespeicherten Signals in den Slave-Teil 7 erfolgt zu einer späteren Zeit durch ein Signal TAKT B', das durch Verzögerung in der Einheit 9 aus dem Signal TAKT A' entsteht; dieses Signal TAKT B' ist ebenfalls in Fig. 1B eingezeichnet. Das Ausgangssignal des Slave-Teils 7 gibt somit zu diesem Zeitpunkt an, ob das UND-Glied 5 ordnungsgemäss angesprochen hat oder nicht. Wenn kein Fehler aufgetreten ist, erscheint am Ausgang des Slave-Teils 7 ein Signal mit dem logischen Wert «0».

Der Prüfoszillator CHK OSZ 8 arbeitet mit derselben Frequenz und synchron zum Oszillator OSZ 2 (vgl. Fig. 1B). Wenn, wie im bisher beschriebenen Ausführungsbeispiel, eine Prüfung nur während des Zeitsignals $T_2$ erfolgt, darf die Speicherung des Ausgangssignals vom UND-Glied 5 nur während dieser Zeit erfolgen, da in anderen Fällen die nicht erfüllte Bedingung im UND-Glied 5 zu einer Fehleranzeige führen würde, selbst wenn die T-Ringe ordnungsgemäss arbeiten. Zum Ausblenden der für das Setzen des Master-Teils 6 zulässigen Signale TAKT A' während der Zeit $T_2$ wird eine Verknüpfungsschaltung (10) verwendet, mit der das Ausgangssignal eines ODER-Glieds, dem die Eingangssignale $T_2$ der beiden T-Ringe zugeführt werden, in einem nachgeschalteten UND-Glied mit dem Signal TAKT A' verknüpft werden.

In einer anderen Ausführungsform kann die Frequenz des Prüfoszillators 8 so herabgesetzt werden, dass dieser nur jeweils zur Zeit $T_2$ ein Signal TAKT A' abgibt.

Zum Zurücksetzen der T-Ringe und der Master-Slave-Kippstufe, beispielsweise beim Einschalten des Systems, dient eine Rücksetzleitung RS 12.

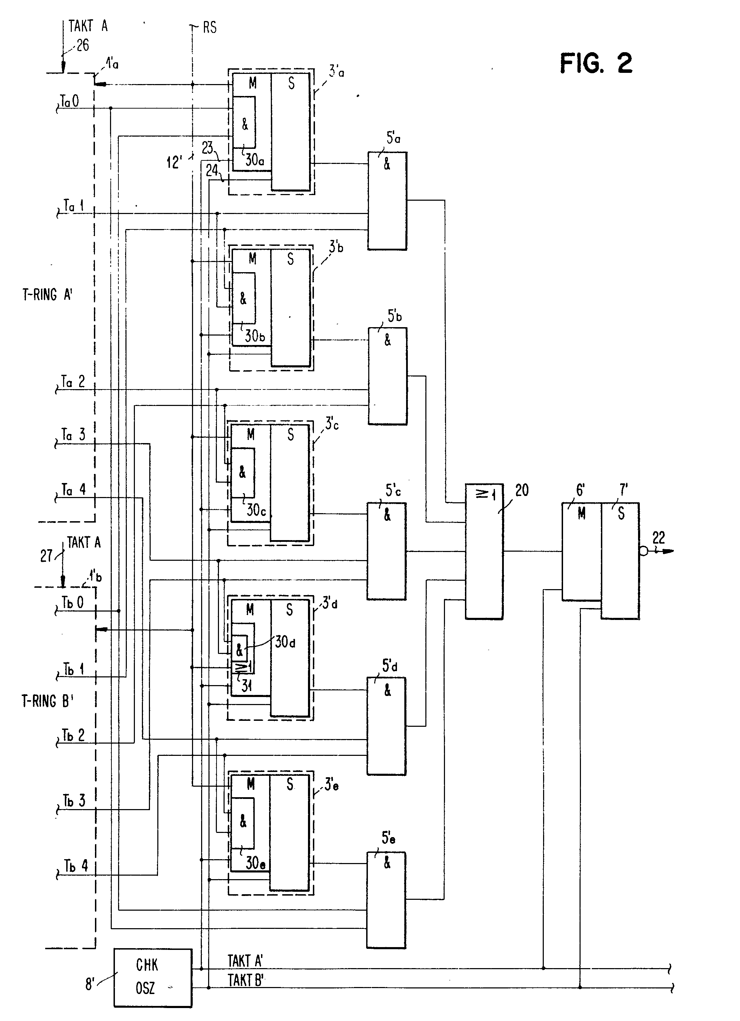

Eine vollständige Prüfschaltung zur Überwachung aller Zeitsignale $T_0$ bis $T_4$ zeigt Fig. 2. In dieser Figur tragen Elemente, die den in Fig. 1 dargestellten entsprechen, dieselben Bezugszeichen, doch wurden sie mit einem zusätzlichen Strich versehen. Als Verzögerungseinrichtungen 3a' bis 3e' in Fig. 2 sind hier Flip-Flp-Schaltungen vom Typ Master-Slave gewählt worden. Diese Verzögerungs-Schaltungen werden zu Zeitpunkten gesetzt (d.h. sie übernehmen die an ihren Eingängen anstehenden Signale), die durch die Taktimpulse eines unabhängigen Prüfoszillators CHK OSZ 8' bestimmt werden. Zum Zeitpunkt des Signals TAKT A', das über Leitung 23 den Master-Teilen der Schaltungen 3' zugeführt wird, stellt sich der Master-Teil auf den Wert ein, der durch die Eingangssignale bestimmt ist. Diese Eingangssignale sind jeweils zwei übereinstimmende Zeitsignale der beiden T-Ringe A' und B', die einem dem Master-Teil vorgeschalteten UND-Glied $30_a$ bis $30_e$ zugeführt werden. Die im Master-Teil gespeicherte Information ist also nur dann Eins, wenn beide Zeitsignale $T_i$ vorhanden sind. Zum Zeitpunkt TAKT B', der den Slave-Teilen über Leitung 24 zugeführt wird, gelangt die im Master-Teil gespeicherte Information in den Slave-Teil. Das Ausgangssignal des Slave-Teils ist nur dann Eins, wenn beide Zeitsignale am Eingang des Master-Teils vorhanden waren. Die Verzögerung der Master-Slave-Kippstufen 3' ist so gewählt, dass sie gerade der Dauer $t_i$ eines Zeitsignals $T_i$ entspricht. Das Ausgangssignal der Master-Slave-Kippstufe wird zusammen mit zusätzlichen Zeitsignalen beider T-Ringe einem der UND-Glieder 5a' bis 5e' zugeführt, die unmittelbar den Verzögerungsgliedern nachgeschaltet sind. Das UND-Glied $5_a'$ verknüpft somit beispielsweise die nicht verzögerten Zeitsignale $T_{a1}$ und $T_{b1}$ mit den um einen Zeitabschnitt verzögerten Zeitsignalen $T_{a0}$ und $T_{b0}$. Nur wenn alle diese Signale gleichzeitig vorhanden sind, ergibt sich am UND-Glied $5_a'$ ein positives Ausgangssignal, das einem ODER-Glied 20 zugeführt wird. Der Ausgang des ODER-Glieds 20 ist mit dem Eingang einer weiteren Master-Slave-Kippstufe 6', 7' (Anzeige-Flip-Flop) verbunden. Das invertierte Ausgangssignal dieser Kippstufe wiederum stellt das Fehlersignal dar, wenn es den Wert Eins annimmt.

Das Setzen der Master-Slave-Kippstufe 6', 7' erfolgt zu den vom unabhängigen Prüfoszillator CHK OSZ bestimmten Zeitpunkten TAKT A' und TAKT B'. Die beiden Oszillatoren arbeiten mit gleicher Frequenz und synchron (vgl. Fig. 1B).

Die ODER-Verknüpfung der Zeitsignale $T_{a1}$ und $T_{b1}$ wird in der Kippstufe $3_b'$ verzögert und im UND-Glied $5_b'$ mit den nicht verzögerten Zeitsignalen $T_{a2}$ und $T_{b2}$ verknüpft. In entsprechender Weise verfahren die Elemente $3_c'$ und $5_c'$ mit den Zeitsignalen $T_{a2}$, $T_{b2}$ und $T_{a3}$, $T_{b3}$. Die Signale $T_{a3}$, $T_{b3}$ werden in der Kippstufe $3_d'$ verzögert und dem UND-Glied $5_d'$ mit den nicht verzögerten Signalen $T_{a4}$ und $T_{b4}$ verknüpft. Im dargestellten Beispiel ist $T_4$ das letzte Zeitsignal innerhalb eines Zyklus; das darauffolgende Zeitsignal ist wiederum $T_0$. In der Kippstufe $3_e'$ werden daher die Zeitsignale $T_{a4}$ und $T_{b4}$ verzögert und im UND-Glied $5_e'$ mit den unverzögerten Zeitsignalen $T_{a0}$ und $T_{b0}$ verknüpft.

Das ODER-Glied 20 erzeugt ein Fehlersignal im Kippglied 6', 7', wenn irgendeine Zeitbedingung innerhalb des Zyklus der Zeitsignale $T_0$ bis $T_4$ verletzt ist. Die richtige Aufeinanderfolge dieser Zeitsignale wird durch die Schaltung in Fig. 2 somit vollständig überprüft.

Umfasst der Zyklus der Zeitsignale mehr als die Zeitsignale $T_0$ bis $T_4$, so kann die Prüfschaltung in Fig. 2 durch Einfügen weiterer Glieder 3' und 5' erweitert werden. Wenn mehr als zwei Taktgeber überprüft werden sollen, kommen Verknüpfungsglieder mit einer grösseren Anzahl von Eingangsleitungen in Betracht; auch können andere Kombinationen von verzögerten und nicht-verzögerten Zeitsignalen gewählt werden.

Bei der Zeitsteuerung mikroprogrammierter Systeme benötigen manche Mikroinstruktionen nicht den gesamten Zyklus $T_0$ bis $T_4$, sondern kommen mit weniger Zeitabschnitten aus. Sind beispielsweise nur drei Zeitabschnitte erforderlich, so muss jeder T-Ring die Sequenz $T_0$, $T_1$, $T_4$ erzeugen. Der letzte Zeitabschnitt $T_4$ ist unbedingt erforderlich, da mit ihm beispielsweise Endroutinen durchlaufen werden oder der Operationscode der nächsten Instruktion ausgelesen wird. Damit die Prüfschaltung in Fig. 2 auch beim erzwungenen Fortschalten der T-Ringe zum Zeitsignal $T_4$ richtig arbeitet, müssen die Kippschaltungen $3_a'$, $3_b'$, $3_c'$ und $3_e'$ auf den Wert Null zurückgesetzt werden, die Kippschaltung $3_d'$ dagegen auf den Wert Eins. Dies erfolgt mit Hilfe eines Rückstellsignals auf Leitung RS 12', das nur dem Kippglied $3_d'$, d.h. dem vorletzten innerhalb der Reihe $3_a'$ bis $3_e'$, am Setzeingang zugeführt wird (über ein ODER-Glied 31, dessen zweiter Eingang das Ausgangssignal des UND-Glieds 30d ist), allen anderen Kippgliedern jedoch am Rückstelleingang. Dadurch wird gewährleistet, dass beim Erzwingen des Zeitsignals $T_4$ das UND-Glied $5_d'$ die nicht verzögerten Zeitsignale $T_{a4}$, $T_{b4}$ und die verzögerten (künstlichen) Zeitsignale $T_{a3}$ und $T_{b3}$ empfängt. Ohne das erzwungene Setzen der Kippschaltung $3_d'$ würde auf der Leitung 22 ein Fehlersignal erscheinen, obwohl keine Fehlerbedingung vorliegt.

Bei Prüfschaltungen für T-Ringe mit einer anderen Anzahl von Zeitsignalen $T_i$ muss jeweils die Verzögerungseinrichtung für die Vorgänger des letzten Zeitsignals durch das Rücksetzsignal gesetzt werden.

Die Verwendung von Master-Slave-Kippgliedern als Verzögerungseinrichtungen ermöglicht es, die gesamte Prüfschaltung in integrierter Bauweise herzustellen und zusammen mit den T-Ringen auf einem Halbleiterplättchen anzuordnen. Die Eigenschaften und Parameter aller Schaltungen auf diesem Plättchen sind daher optimal aneinander angepasst.

Die Steuerung des Anzeige-Flip-Flops durch einen unabhängigen Prüfoszillator gewährleistet, dass auch bei Fehlern im Signal TAKT A die Stellung des Master-Teils 6 abgefragt und ein Fehlersignal auf die Ausgangsleitung 22 gegeben wird.

In einer vereinfachten Ausführungsform können die Signale TAKT A und TAKT A' auch vom gleichen Oszillator abgeleitet werden, z.B. wenn dieser sehr fehlersicher ist.

**Patentansprüche**

1. Prüfschaltung für mindestens zwei synchron arbeitende Taktgeber, die Impulse eines der Taktgeber über eine Verzögerungseinrichtung empfängt, dadurch gekennzeichnet, dass zur Prüfung der zeitlichen Beziehung zwischen aufeinanderfolgenden Taktimpulsen und der Synchronität der Taktgeber eine logische Verknüpfungsschaltung (NAND-Glied 5) vorgesehen ist, die mindestens einen ersten, unverzögerten Impuls ($T_{a2}$) eines ersten Taktgebers (1a) und mindestens einen zweiten, verzögerten Impuls (z.B. $T_{b1}$) eines zweiten Taktgebers (1b) empfängt, wobei die Verzögerung (im Schaltglied 3b) des zweiten Impulses ein ganzes Vielfaches der Taktperiode darstellt, so dass er nur im fehlerfreien Betrieb der Taktgeber zeitlich mit dem ersten Impuls zusammenfällt.

2. Prüfschaltung nach Anspruch 1, dadurch gekennzeichnet, dass die logische Verknüpfungsschaltung (5) die unverzögerten, einander entsprechenden Impulse ($T_{a2}$, $T_{b2}$) aller Taktgeber (1a, 1b) und mindestens einen verzögerten Impuls ($T_{b1}$) eines Taktgebers empfängt.

3. Prüfschaltung nach Anspruch 1 oder 2, dadurch gekennzeichnet, dass das Ausgangssignal der logischen Verknüpfungsschaltung (5) einer Anzeigeschaltung (6, 7) von Typ Master-Slave-Flip-Flop zugeführt wird, die von einem unabhängigen Prüfoszillator (8) gesetzt wird.

4. Prüfschaltung nach einem der Ansprüche 1 bis 3, dadurch gekennzeichnet, dass als Verzögerungseinrichtung für Taktsignale Master-Slave-Flip-Flops (3′, Fig. 2) verwendet werden.

5. Prüfschaltung nach Anspruch 4, dadurch gekennzeichnet, dass die Verzögerungs-Flip-Flops (3′) vom unabhängigen Prüfoszillator (8) gesetzt werden.

6. Prüfschaltung nach einem der Ansprüche 1 bis 5, dadurch gekennzeichnet, dass in der Zeitsignalfolge $T_0$, $T_1$, ... $T_L$ zweier Taktgeber (T-Ring A 1a, T-Ring B 1b) ein Zeitsignal ($T_{ai}$) des ersten Taktgebers mit dem entsprechenden unverzögerten Zeitsignal ($T_{bi}$) des zweiten Taktgebers und weiteren verzögerten Zeitsignalen ($T_{bi-1}$, $T_{bi-2}$) verknüpft wird und dass der Prüfoszillator nur während des Zeitsignales ($T_i$) Setzimpulse an die Anzeigeschaltung liefert.

7. Prüfschaltung nach einem der Ansprüche 1 bis 5, dadurch gekennzeichnet, dass in der Zeitsignalfolge $T_0$, $T_1$ ... $T_L$ zweier Taktgeber (T-Ring A 1′a, T-Ring B 1′b; Fig. 2) die Kombination der Zeitsignale $T_{a\,i+1}$, $T_{b\,i+1}$ und der um eine Taktdauer ($t_i$) verzögerten Zeitsignale $T_{ai}$, $T_{bi}$ (mit i = 0, ... L; L+1 = 0) in UND-Gliedern (5′, Fig. 2) verknüpft werden, deren Ausgangssignale über ein ODER-Glied (20) einem Anzeige-Flip-Flop (6′, 7′) zugeführt werden.

8. Prüfschaltung nach Anspruch 7, dadurch gekennzeichnet, dass die zu verzögernden Zeitsignale $T_{ai}$, $T_{bi}$ den Verzögerungs-Flip-Flops (3) über ein UND-Glied (30) zugeführt werden.

9. Prüfschaltung nach Anspruch 8, dadurch gekennzeichnet, dass dem Setz-Eingang des Verzögerungs-Flip-Flops (3′d) für die Zeitsignale $T_{a\,L+1}$, $T_{b\,L-1}$ ein die restlichen Verzögerungs-Flip-Flops zurücksetzendes Signal (RS) zusammen mit der UND-Verknüpfung der zu verzögernden Zeitsignale zugeführt wird.

10. Prüfschaltung nach einem der Ansprüche 1 bis 9, dadurch gekennzeichnet, dass die Taktgeber Teil einer Datenverarbeitungsanlage sind.

11. Prüfschaltung nach Anspruch 10, dadurch gekennzeichnet, dass die Taktgeber Zeitsignale für die Steuerung der Ausführung von Mikroinstruktionen abgeben.

12. Prüfschaltung nach einem der Ansprüche 1 bis 11, dadurch gekennzeichnet, dass die Prüfschaltung in integrierter Bauweise ausgeführt ist.

**Revendications**

1. Circuit de test pour au moins deux générateurs de cadence fonctionnant de façon synchrone, qui reçoit des impulsions d'un des générateurs de cadence à travers un dispositif à retard, caractérisé en ce qu'il est prévu pour vérifier la relation temporelle entre des impulsions de cadence successives et le synchronisme des générateurs de cadence, un circuit logique (élément ET 5) qui reçoit au moins une première impulsion non retardée ($T_{a2}$) d'un premier générateur de cadence (1a) et au moins une seconde impulsion retardée (par exemple $T_{b1}$) d'un second générateur de cadence (1b), le retard (dans l'élément de commutation 3b) de la seconde impulsion représentant un multiple entier de la période de cadence, de telle sorte que, seulement en fonctionnement sans erreur, les générateurs de cadence coïncident dans le temps avec la première impulsion.

Circuit de test selon la revendication 1 caractérisé en ce que le circuit logique (5) reçoit les impulsions non retardées correspondantes ($T_{a2}$, $T_{b2}$) de tous les générateur de cadence (1a, 1b) et au moins une impulsion retardée ($T_{b1}$) d'un générateur de cadence.

3. Circuit de test selon la revendication 1 ou 2, caractérisé en ce que le signal de sortie du circuit logique (5) est appliqué à un circuit d'affichage (6, 7) du type bascule maître-esclave qui est enclenchée par un oscillateur de test indépendant (8).

4. Circuit de test selon l'une des revendications 1 à 3, caractérisé en ce qu'on utilise des bascules du type maître-esclave (3′, figure 2), comme dispositif à retard pour les signaux de cadence..

5. Circuit de test selon la revendication 4, caractérisé en ce que les bascules à retard (3′) sont enclenchées par l'oscillateur de test indépendant (8).

6. Circuit de test selon l'une des revendications 1 à 5, caractérisé en ce que, durant la séquence de signaux de temps $T_0$, $T_1$, ... $T_L$ de deux générateurs de cadence (anneau T A 1a, anneau T B 1b), un signal de temps ($T_{ai}$) du premier générateur de cadence est logiquement lié au signal de temps non retardé correspondant ($T_{bi}$) du second générateur de cadence et à d'autres signaux de temps retardés ($T_{bi-1}$, $T_{bi-2}$), et en ce que l'oscillateur de test fournit des impulsions d'enclenchement au circuit d'affichage seulement pendant le signal de temps ($T_i$).

7. Circuit de test selon l'une des revendications 1 à 5, caractérisé en ce que, durant la séquence de signaux de temps $T_0$, $T_1$, ... $T_L$ de deux générateurs de cadence (anneau T A 1′a, anneau T B 1′b; figure 2), les signaux de temps $T_{a\,i+1}$, $T_{b\,i+1}$ et les signaux de temps $T_{ai}$, $T_{bi}$, retardès d'une durée de cadence ($t_i$) (avec i = 0, ..., L; L+i = 0) sont logiquement combinés en circuits ET (5′, figure 2) dont les signaux de sortie sont appliqués à une bascule d'affichage (6′, 7′) à travers un circuit OU (20).

8. Circuit de test selon la revendication 7, caractérisé en ce que les signaux de temps à retarder $T_{ai}$, $T_{bi}$ sont appliqués aux bascules à retard (3) à travers un circuit ET (30).

9. Circuit de test selon la revendication 8, caractérisé en ce qu'on applique à l'entrée d'enclenchement de la bascule à retard (3′d) pour les signaux de temps $T_{a\,L-1}$, $T_{b\,L-1}$, un signal (RS) restaurant les bascules à retard restantes et les signaux de temps à retarder combinés en ET logique.

10. Circuit de test selon l'une des revendications 1 à 9, caractérisé en ce que les générateurs de cadence représentent une partie d'un système de traitement de données.

11. Circuit de test selon la revendication 10, caractérisé en ce que les générateurs de cadence fournissent des signaux de temps pour commander l'exécution de microinstructions.

12. Circuit de test selon l'une des revendications 1 à 11, caractérisé en ce que le circuit de test a une structure intégrée.

## Claims

1. Test circuit for at least two synchronously operating clocks which receives pulses from one of the clocks via a delay device, characterized in that for checking the time relation between successive clock pulses and the synchronism of the clocks a logic circuit (NAND gate 5) is provided which receives at least a first undelayed pulse ($T_{a2}$) of a first clock (1a) and at least a second delayed pulse (e.g. $T_{b1}$) of a second clock (1b), the delay (in switching unit 3b) of the second pulse representing an integral multiple of the clock period so that with respect to time it coincides with the first pulse only in an error-free operation of the clocks.

2. Test circuit as claimed in claim 1, characterized in that the logic circuit (5) receives the undelayed pulses ($T_{a2}$, $T_{b2}$) of all clocks (1a, 1b) and at least one delayed pulse ($T_{b1}$) of one clock.

3. Test circuit as claimed in claim 1 or 2, characterized in that the output signal of the logic gate (5) is applied to an indicating circuit (6, 7) of the master-slave flipflop type which is set by an independent test oscillator (8).

4. Test circuit as claimed in any one of claims 1 to 3, characterized in that master-slave flipflops (3', Fig. 2) are used as a delay device for clock signals.

5. Test circuit as claimed in claim 4, characterized in that the delay flipflops (3') are set by the independent test oscillator (8).

6. Test circuit as claimed in any one of claims 1 to 5, characterized in that in the time signal sequence $T_0$, $T_1$; ... $T_L$ of two clocks (T-ring A 1a, T-ring B 1b) a time signal ($T_{ai}$) of the first clock is logically combined with the corresponding undelayed time signal ($T_{bi}$) of the second clock and further delayed time signals ($T_{bi-1}$, $T_{bi-2}$), and that the test oscillator supplies set pulses to the display circuit only during the time signal ($T_i$).

7. Test circuit as claimed in any one of claims 1 to 5, characterized in that in the time signal sequence $T_0$, $T_1$, ... $T_L$ of two clocks (T-ring A 1'a, T-ring B 1'b; Fig. 2) the time signals $T_{a\,i+1}$, $T_{b\,i+1}$ are logically combined with the time signals $T_{ai}$, $T_{bi}$ delayed by one cycle period ($t_i$) (with $i = 0$, ... L; L+1 = 0) in AND gates (5', Fig. 2) whose output signals are applied via an OR gate (20) to an indicating flipflop (6', 7').

8. Test circuit as claimed in claim 7, characterized in that the time signals $T_{ai}$, $T_{bi}$ to be delayed are applied to the delay flipflops (3) via an AND gate (30).

9. Test circuit as claimed in claim 8, characterized in that the set input of delay flipflop (3'd) for the time signals $T_{a\,L-1}$, $T_{b\,L-1}$, receives a signal (RS) resetting the remaining delay flipflops, together with the logic AND combination of the time signals to be delayed.

10. Test circuit as claimed any one of claims 1 to 9, characterized in that the clocks are part of a data processing system.

11. Test circuit as claimed in claim 10, characterized in that the clocks supply time signals for controlling the execution of micro instructions.

12. Test circuit as claimed in any one of claims 1 to 11, characterized in that the test circuit is implemented as an integrated circuit.

**FIG. 1A**

**FIG. 1B**

FIG. 2

0 012 185